Europäisches Patentamt

European Patent Office

Office européen des brevets

(19)

(11) Numéro de publication : **0 627 629 A1**

## (12) DEMANDE DE BREVET EUROPEEN

(21) Numéro de dépôt : **94401199.8**

(22) Date de dépôt : **31.05.94**

(51) Int. Cl.⁵ : **G01R 7/06**

(30) Priorité : **04.06.93 FR 9306698**

(43) Date de publication de la demande :
**07.12.94 Bulletin 94/49**

(84) Etats contractants désignés :
**DE GB IT**

(71) Demandeur : **SOCIETE D'APPLICATIONS
GENERALES D'ELECTRICITE ET DE
MECANIQUE SAGEM
6, Avenue d'Iéna
F-75783 Paris Cédex 16 (FR)**

(72) Inventeur : **Levesque, Xavier
9 Grand'Place
F-95000 Cergy (FR)**

(74) Mandataire : **Bloch, Gérard et al
2, square de l'Avenue du Bois
F-75116 Paris (FR)**

(54) **Logomètre.**

(57) Logomètre comportant deux bobines (1, 2) pour respectivement produire deux champs magnétiques, de directions (10, 11) différentes et d'intensités fonction d'un signal à afficher (22), et faire dévier un afficheur en fonction dudit signal (22), dans lequel les bobines (1, 2) sont disposées de façon telle que lesdites directions (10, 11) des champs magnétiques sont inclinées l'une sur l'autre.
- Application à l'affichage de la vitesse d'une voiture.

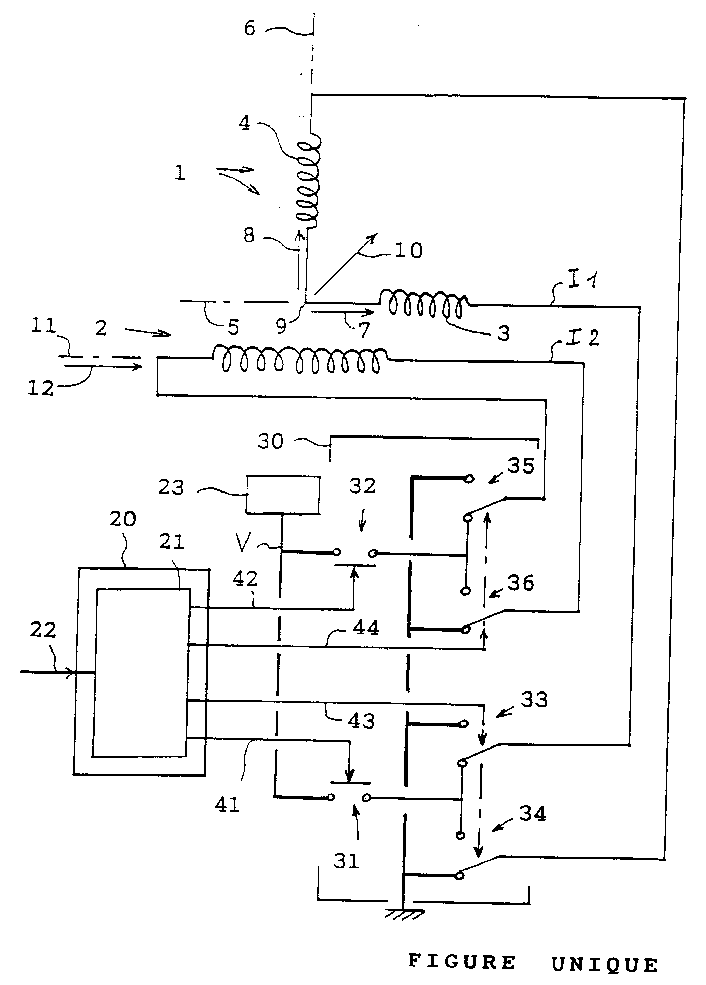

FIGURE UNIQUE

EP 0 627 629 A1

Jouve, 18, rue Saint-Denis, 75001 PARIS

La présente invention concerne un logomètre comportant deux bobines pour respectivement produire deux champs magnétiques, de directions différentes et d'intensités fonction d'un signal à afficher, et faire dévier un afficheur en fonction dudit signal.

Un logomètre, ou indicateur à afficheur rotatif, comporte un mouvement d'entraînement servant à faire dévier l'afficheur en fonction d'un signal de commande dont la valeur est ainsi visualisée par l'angle de déviation de l'afficheur.

Comme il s'agit d'effectuer un mouvement relatif entre un élément de repérage et une échelle de valeurs, l'afficheur peut être un disque rotatif portant, en périphérie, l'échelle de valeurs passant dans une fenêtre de lecture fixe.

Le plus souvent, il s'agit d'une aiguille montée rotative devant un cadran fixe portant une échelle de valeurs. Dans une voiture, par exemple, un signal issu d'un capteur de vitesse commande la déviation de l'afficheur de l'indicateur de vitesse. D'autres indicateurs fournissent la vitesse de rotation du moteur, sa température et les niveaux de carburant et d'huile.

L'étendue angulaire de la plage de déviation de l'afficheur dépend de la précision souhaitée. Ainsi, toujours dans l'exemple de la voiture, les indicateurs de vitesse ont une plage voisine de 360 degrés alors que la plage des autres indicateurs est limitée à environ 90 degrés.

Selon l'étendue de la plage de déviation, les mouvements d'entraînement utilisés sont plus ou moins complexes.

Pour disposer d'une plage de 360 degrés, il est connu d'utiliser deux bobines orthogonales, électriquement indépendantes. Comme les deux champs magnétiques qu'elles créent sont orthogonaux, l'un ne peut contrarier l'effet de l'autre et leur effet composé crée un couple de forces magnétiques d'efficacité maximale commandant la rotation d'une pièce magnétique solidaire de l'axe portant l'afficheur. Chacun des deux courants traversant les deux bobines peut avoir deux états, direct ou inversé, si bien qu'aux quatre paires de courants maximaux possibles correspondent quatre déviations, "nord", "ouest", "sud" et "est". Les déviations intermédiaires sont obtenues en réduisant l'un au moins des deux courants.

Lorsqu'une plage de 90 degrés suffit, il n'est donc pas nécessaire d'inverser les courants, si bien que le circuit de commande des bobines peut être simplifié en réunissant une extrémité des deux bobines à un point commun et en commandant en propre chacune des deux autres extrémités.

Il existe cependant des indicateurs pour lesquels on souhaite disposer d'une plage de déviation excédant 90 degrés et pouvant approcher 180 degrés. Cela permet d'avoir un affichage plus précis ou simplement de définir, à l'intérieur de la plage maximale possible, une plage utile dans laquelle on applique à l'aiguille un couple moteur relativement élevé, nettement supérieur à celui dû à un ressort de rappel en spirale qui est susceptible de fausser la déviation aux extrémités de la plage maximale possible, là où le couple moteur serait moindre.

Pour satisfaire à ce besoin, on utilisait, dans l'art antérieur, le mouvement le plus complexe, à bobines indépendantes, et on inversait le sens de l'un des courants pour obtenir une plage de 180 degrés. Il fallait donc prévoir un inverseur de courant, ce qui, par rapport au mouvement le plus simple, était d'un coût plus élevé et pouvait créer une discontinuité dans la commande et donc dans la déviation.

La présente invention vise à pallier ces inconvénients, tout' en permettant toujours, quitte à inverser les courants dans les bobines, d'obtenir une plage de déviation de 360 degrés.

A cet effet, l'invention concerne un logomètre du type mentionné ci-dessus, caractérisé par le fait que les bobines sont disposées de façon telle que lesdites directions des champs magnétiques sont inclinées l'une sur l'autre.

L'inclinaison des directions des champs magnétiques sous-entend une inclinaison comprise entre 0 et 90 degrés et exclut l'orthogonalité.

On soulignera que, si l'un des champs, certes, présente encore, par rapport à l'autre, la composante orthogonale nécessaire pour créer un couple d'entraînement en rotation, il a en plus une composante colinéaire avec l'autre champ, qui s'y ajoute ou s'en retranche. De ce fait, si, dans un cas extrême, les deux champs inclinés sont presque colinéaires et de sens opposés, on peut obtenir une plage de déviation angulaire atteignant presque 180 degrés en faisant varier le rapport entre les courants traversant les bobines.

Avantageusement, les deux bobines sont disposées pour que l'une desdites directions soit inclinée sensiblement d'un angle de 135 degrés sur l'autre.

On dispose ainsi d'une plage de 135 degrés sans devoir inverser les courants dans les bobines. Comme il reste, jusqu'à 180 degrés, une marge de 45 degrés, la composante orthogonale d'un champ par rapport à l'autre conserve une intensité suffisante pour exercer un couple moteur bien supérieur à celui d'un éventuel mécanisme de rappel, tel qu'un ressort. En outre, comme 135 degrés est un angle facile à déterminer trigonométriquement, la détermination de la valeur relative entre les courants à appliquer, pour obtenir une déviation voulue, est simplifiée.

Avantageusement' toujours, l'une des deux bobines comporte deux bobinages agencés pour respectivement créer deux champs orthogonaux entre eux.

On peut ainsi bobiner, sur un mandrin en croix très simple, le nombre voulu de spires pour chaque bobinage.

En particulier, les deux bobinages peuvent être disposés de façon à ce que le champ de l'un des deux bobinages soit colinéaire avec le champ de ladite autre bobine.

La composition des champs des deux bobines, pour déterminer la valeur relative entre les courants dans les bobines, est alors très simple puisque les champs colinéaires ont une résultante calculée en les ajoutant ou en les retranchant et que le champ de l'autre bobinage n'est pas affecté et s'ajoute vectoriellement à angle droit avec le champ résultant des deux champs colinéaires ci-dessus pour fournir le champ résultant total commandant l'afficheur.

On peut prévoir des moyens de génération d'un signal de commande de moyens modulateurs agencés pour appliquer, à l'une au moins des bobines, un courant de valeur moyenne fonction du signal à afficher et qui est reçu par les moyens de génération du signal de commande.

On règle ainsi l'intensité du champ magnétique correspondant et donc l'orientation du champ magnétique total.

En particulier, il est avantageux de prévoir que les moyens modulateurs comportent au moins un interrupteur agencé pour appliquer, à l'une au moins des bobines, des impulsions périodiques d'un courant d'amplitude déterminée et dont la durée est réglée par les moyens de génération du signal de commande.

L'invention sera mieux comprise à l'aide de la description suivante de la forme de réalisation préférée du logomètre de l'invention, dont les deux bobines du mouvement et leurs circuits de commande sont représentés sur la figure unique du dessin annexé.

Le mouvement du logomètre comporte deux bobines 1 et 2. La bobine 1 est, dans cet exemple, formée de deux bobinages 3 et 4 en série disposés, ici, de façon telle que leurs deux axes magnétiques respectifs 5 et 6 soient à angle droit. Toujours dans le cas particulier de cet exemple, la bobine 2 comporte 2N spires (N: positif) tandis que chacun des bobinages 3 et 4, semblables par ailleurs, en comporte N. Les sens de bobinage des spires des bobinages 3 et 4 ont ici été choisis pour que les champs magnétiques 7 et 8 respectivement créés par les bobinages 3 et 4 selon la direction de leur axe magnétique 5 et 6 soient, pour un sens donné du courant I1 les traversant, simultanément orientés vers l'extérieur du mouvement, en partant du point de croisement 9 des axes 5 et 6. De ce fait, les champs magnétiques orthogonaux 7 et 8 sont d'égale amplitude et leur résultante 10 est orientée selon la bissectrice de l'angle droit formé par les champs 7 et 8, avec un sens dépendant de celui du courant I1 traversant la bobine 1.

La bobine 2, d'axe magnétique 11, crée un champ magnétique 12 colinéaire avec l'axe 11, ici parallèle à l'axe 5. Pour la clarté du dessin, les bobines 1 et 2 sont espacées entre elles, mais on comprendra que leurs spires ont un diamètre suffisant pour que leurs champs respectifs se composent entre eux et créent un champ résultant dans un volume commun où est situé un élément magnétique, non représenté. Cet élément magnétique, entraîné en rotation par ce champ résultant, est solidaire de l'axe, perpendiculaire au plan de la figure, d'une aiguille montée rotative dans un plan parallèle à ce plan.

De ce fait, les champs colinéaires 7 et 12 s'ajoutent ou se soustraient selon leurs sens respectifs et leur résultante selon l'axe 5 et 11 se combine vectoriellement à angle droit avec le champ 8 pour fournir le champ résultant total.

Un microcontrôleur 20 du logomètre comporte un modulateur 21 recevant de l'extérieur un signal de déviation angulaire 22 à afficher et commandant, par des signaux de commande de modulation 41, 42, 43 et 44, l'état d'un ensemble 30 d'interrupteurs commandables, ici des portes électroniques analogiques 31 à 36, en fonction du signal de déviation angulaire 22. Les interrupteurs 31 et 32 sont des interrupteurs simples à deux bornes, tandis que les interrupteurs 33-36 sont des inverseurs à trois bornes: une borne commune, une borne "travail" et une borne "repos".

Dans cet exemple, les deux inverseurs 33 et 34 sont jumelés dans un même circuit intégré et donc commandés par un seul signal commun 43. Il en est de même pour les deux inverseurs 35 et 36, commandés par le signal 44.

Une source 23 de tension continue fournit une tension V, par rapport à la masse, qui est appliquée à l'une des bornes des inverseurs 31 et 32, dont l'autre borne est reliée, pour l'un, à la borne repos de l'inverseur 33 et à la borne travail de l'inverseur 34, et, pour l'autre, à la borne repos de l'inverseur 35 et à la borne travail de l'inverseur 36. Les bornes communes des inverseurs 33-34 et 35-36 sont chacune reliées à une extrémité propre des bobines respectivement 1 et 2.

Les bornes travail des inverseurs 33 et 35 et les bornes repos des inverseurs 34 et 36 sont reliées à la masse.

Les courants I1 et I2 transmis par les interrupteurs ci-dessus aux bobines 1 et 2 déterminent la déviation angulaire de l'aiguille, comme cela est expliqué ci-après.

Les tableaux 1 et 2 fournissent la valeur de l'angle θ, par rapport aux axes parallèles 5 et 11, définissant l'orientation du champ résultant total en fonction des courants I1 et I2.

On comprendra que, dans la mesure où le couple moteur entraînant l'aiguille sous l'effet du champ résultant total est suffisant pour vaincre nettement les frottements d'un éventuel couple de rappel à une position de repos créé, par exemple, par un ressort en spirale, seul compte le rapport des courants I1 et I2 pour déterminer, à n radians près, l'angle θ de déviation, c'est-à-dire sa direction, et non les valeurs absolues de ces deux courants. L'ambiguïté subsistant quant au sens du champ résultant est levée par les signes définissant les sens des courants.

Le tableau 1 fournit les valeurs des angles de déviation θ pouvant être obtenues en commandant par tout ou rien les bobines 1 et 2 par un courant de valeur ± I ou zéro, ou une valeur intermédiaire si l'autre courant est nul.

## TABLEAU 1

| I1 | I2 | I1/I2 | θ (degrés) |
|---|---|---|---|
| 0 | > 0 | + 0 | 0 |
| 0 | < 0 | - 0 | 180 |
| | | | |
| < 0 | 0 | + ∞ | 45 |
| > 0 | 0 | - ∞ | 225 |
| | | | |
| - I | I | - 1 | 20 (tg θ = 1/3) |
| I | - I | - 1 | 200 |
| | | | |
| - I | - I | 1 | 135 |
| I | I | 1 | 315 |

Les deux premières lignes du tableau 1 montrent que, comme on l'aura compris, la bobine 2, seule excitée, permet d'obtenir un champ selon son axe 11, de sens dépendant de celui du courant I2.

Les troisième et quatrième lignes montrent que, de même, la bobine 1 permet de créer un champ 10 selon son axe magnétique, à π/4 ou 5π/4 sur l'axe 5.

Les cinquième et sixième lignes correspondent à des compositions additives des champs colinéaires 7 et 12, avec, d'une ligne à l'autre, inversion simultanée des deux sens des courants.

Les septième et huitième lignes correspondent à des compositions soustractives des champs colinéaires 7 et 12, avec encore, d'une ligne à l'autre, inversion simultanée des deux sens des courants.

Entre ces déviations quantifiées, correspondant à des rapports I1/I2 = 0, 1 ou ∞, existent des valeurs intermédiaires pour des rapports I1/I2 ajustables en réglant, entre O et la valeur I, maximale, la valeur absolue, d'un, au moins, des courants.

Le tableau 2 ci-dessous complète le tableau 1 en fournissant, pour des angles θ croissants, les plages de valeurs à donner aux courants I1 et I2 pour obtenir une dynamique de déviation de 360 degrés. Pour la clarté, les valeurs de courants I1 et I2 inchangées d'une ligne à la suivante sont encadrées, tandis qu'une flèche verticale représente la valeur de l'autre courant qui doit être progressivement modifiée de la valeur fournie par une ligne à celle de la suivante, pour obtenir la suite des déviations intermédiaires entre les deux lignes successives.

## TABLEAU 2

| I1 | I2 | I1/I2 | θ degrés |
|---|---|---|---|
| 0 ↓ | I | 0 | 0 |
| − I | I | − 1 | 20 |
| − I | 0 ↓ | + ∞ | 45 |
| − I | − 0,5I ↓ | − 2 | 90 |
| − I | − I | 1 | 135 |
| 0 ↓ | − I | − 0 | 180 |
| I | − I | − 1 | 200 |
| I | 0 ↓ | − ∞ | 225 |
| I | 0,5 I ↓ | − 2 | 270 |
| I | I | 1 | 315 |
| 0 ↓ | I | 0 | 360 |

On remarque que les déviations multiples de 45 degrés sont obtenues en appliquant des fractions simples du courant I: 0, 0,5 ou 1.

Une commande de la seule amplitude du courant I2 (flèches) permet d'obtenir une déviation de 135 - 45 = 90 degrés. De même l'observation des valeurs constantes encadrées du courant I1 montre que l'on obtient une dynamique de 135 - 20 = 115 degrés avec I1 constant, en commandant, en plus, le sens du courant I2.

En prévoyant deux commandes de réglage des seules amplitudes des courants I1 et I2, on obtient une plage de déviation de 180 - 45 = 135 degrés. Une commande supplémentaire du sens de l'un des deux courants permet de lui donner toute valeur voulue et d'atteindre une plage de variation de 180 ou 360 degrés selon qu'il a ou non aussi été prévu une commande du sens de l'autre courant.

Comme déjà expliqué, il serait possible d'orienter presque parallèlement les champs 10 et 12 des deux bobines 1 et 2 et ainsi d'augmenter de presque 45 degrés certaines des plages de variation indiquées.

La commande des courants I1 et I2 est effectuée par le microcontrôleur 20 en fonction de la valeur du signal de déviation 22. Le microcontrôleur 20 contient en mémoire une table de correspondance équivalente au tableau 2 ainsi que la valeur de la sensibilité angulaire prévue en fonction du signal de déviation 22. Le microcontrôleur 20 calcule, à partir du signal de déviation 22, la déviation angulaire correspondante et, par la table de correspondance, détermine les valeurs des courants I1 et I2, c'est-à-dire les rapports k1 et k2 (-1 $\leq$ k1, k2 $\leq$ +1) entre les courants respectifs I1 et I2 et le courant maximal I. Ces rapports k1 et k2 sont fournis au modulateur 21 qui émet alors les signaux 41 et 42 sous forme d'impulsions périodiques présentant respectivement le facteur de forme $|$k1$|$ et $|$k2$|$.

Les signaux 43 et 44, définissant le sens voulu pour les courants I1 et I2, ne changent d'état que lorsqu'il faut inverser les sens de ces courants, selon les signes de k1 et k2.

La valeur moyenne des courants I1 et I2 est ainsi réglée, dans cet exemple, par modulation de la durée de passage d'un courant connu, ici constant. La fréquence des impulsions 41 et 42 est suffisamment élevée pour que l'inertie électrique des bobines 1 et 2 et l'inertie mécanique de l'élément magnétique entraîné filtrent les variations dans la commande des bobines 1 et 2. Les éléments de maintien, entre deux impulsions, des courants I1 et I2 circulant dans les bobines 1 et 2, éléments assurant aussi la protection contre les surtensions induites par les commutations des courants I1 et I2, tels que diodes ou réseau à résistance et capacité, sont connus et ne sont pas représentés.

Dans le cas où il y aurait plusieurs logomètres, le microcontrôleur 20 pourrait être commun à tous et les gérer en commandant, en partage de temps, les interrupteurs de ceux-ci.

On remarquera que la valeur moyenne des courants I1 et I2 pourrait aussi être réglée par une modulation d'amplitude de ces courants, en utilisant un élément à résistance équivalente réglable, comme un transistor ou une porte analogique, commandé par un courant ou une tension permanent d'amplitude relative |k1| ou |k2| et relié en série avec la bobine 1 ou 2 correspondante.

## Revendications

1. Logomètre comportant deux bobines (1, 2) pour respectivement produire deux champs magnétiques, de directions (10, 11) différentes et d'intensités fonction d'un signal à afficher (22), et faire dévier un afficheur en fonction dudit signal (22), caractérisé par le fait que les bobines (1, 2) sont disposées de façon telle que lesdites directions (10, 11) des champs magnétiques sont inclinées l'une sur l'autre.

2. Logomètre selon la revendication 1, dans lequel les deux bobines (1, 2) sont disposées pour que l'une desdites directions (10, 11) soit inclinée sensiblement d'un angle de 135 degrés sur l'autre (11, 10).

3. Logomètre selon l'une des revendications 1 et 2, dans lequel l'une (1) des deux bobines (1, 2) comporte deux bobinages (3, 4) agencés pour respectivement créer deux champs (7, 8) orthogonaux entre eux.

4. Logomètre selon la revendication 3, dans lequel les deux bobinages (3, 4) sont disposés de façon à ce que le champ (7) de l'un (3) des deux bobinages (3, 4) soit colinéaire avec le champ (11) de ladite autre bobine (2).

5. Logomètre selon l'une des revendications 3 et 4, dans lequel les deux bobinages (3, 4) comportent un nombre (N) sensiblement égal de spires.

6. Logomètre selon l'une des revendications 1 à 5, dans lequel les deux bobines (1, 2) comportent un nombre (2N) sensiblement égal de spires.

7. Logomètre selon l'une des revendications 1 à 6, dans lequel il est prévu des moyens (20, 21) de génération d'un signal de commande (41-44) de moyens modulateurs (31-36) agencés pour appliquer, à l'une au moins des bobines (1, 2), un courant de valeur moyenne fonction du signal à afficher et qui est reçu par les moyens (20, 21) de génération du signal de commande (41-44).

8. Logomètre selon la revendication 7, dans lequel les moyens modulateurs (31-36) comportent au moins un interrupteur (31, 32) agencé pour appliquer, à l'une au moins des bobines (1, 2), des impulsions périodiques d'un courant d'amplitude déterminée et dont la durée est réglée par les moyens (20, 21) de génération du signal de commande (41, 42).

9. Logomètre selon la revendication 8, dans lequel les moyens (20, 21) de génération du signal de commande sont agencés pour commander, en partage de temps, plusieurs interrupteurs (31-36).

FIGURE UNIQUE

EP 0 627 629 A1

Office européen
des brevets
Numero de la demande

**RAPPORT DE RECHERCHE EUROPEENNE**

Numero de la demande

EP 94 40 1199

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | EP-A-0 509 484 (ROHM)<br>--- | | G01R7/06 |
| A | TECHNISCHES MESSEN,<br>vol.51, no.1, Janvier 1985, MUENCHEN,DE<br>pages 34 - 40<br>TRAENLKER 'Messtechnik und Messsignalverarbeitung'<br>* page 35; figures 9.2,9-3 *<br>--- | | |
| A | EP-A-0 511 078 (SAGEM)<br>--- | | |
| A | US-A-2 205 228 (PLAINS)<br>--- | | |
| A | GB-A-2 045 953 (GEN. MOTORS)<br>----- | | |

|  |
|---|
| **DOMAINES TECHNIQUES RECHERCHES (Int.Cl.5)** |
| G01R |

Le présent rapport a été établi pour toutes les revendications

| Lieu de la recherche | Date d'achèvement de la recherche | Examinateur |
|---|---|---|
| LA HAYE | 28 Juin 1994 | Hoornaert, W |